# EUROPÄISCHE PATENTSCHRIFT

(11) **EP 1 172 837 B1**
(45) Veröffentlichungstag und Bekanntmachung des Hinweises auf die Patenterteilung: **26.11.2008**
(21) Anmeldenummer: 01116082.7
(22) Anmeldetag: 03.07.2001
(51) Int. Cl.: H01J 37/30, H01J 37/317

(54) **Verfahren zur Elektronenstrahl-Lithographie und elektronen-optisches Lithographiesystem**
Electron beam lithography method and electron-optical lithography device
Procédé de lithographie par faisceau d'électrons et dispositif d'optique électronique pour la lithographie

(30) Priorität: 14.07.2000 DE 10034412
(43) Veröffentlichungstag der Anmeldung: 16.01.2002
(73) Patentinhaber: Carl Zeiss NTS GmbH, 73446 Oberkochen (DE)
(72) Erfinder: Benner, Gerd, Dr., 73434 Aalen (DE)
(74) Vertreter: Gnatzig, Klaus

(56) Entgegenhaltungen:
- EP-A- 0 367 496
- EP-A- 1 006 556
- EP-A- 1 087 420
- US-A- 5 545 902

## Beschreibung

In der Elektronenstrahl-Lithographie werden zwei verschiedene Verfahren eingesetzt, nämlich das Elektronenstrahlschreiben und die Elektronenstrahl-Projektions-Lithographie.

Beim Elektronenstrahlschreiben wird das Substrat mit Hilfe eines fokussierten Elektronenstrahls sequentiell belichtet, wobei der Strahl entweder zeilenförmig das ganze Präparat abrastert und durch entsprechendes Ausblenden des Strahles die gewünschte Struktur auf das Objekt geschrieben wird, oder wie beim Vekor-Scan-Verfahren der fokussierte Elektronenstrahl nur über die zu belichtenden Bereiche geführt wird. Das Elektronenstrahlschreiben zeichnet sich durch eine hohe Flexibilität aus, da die Schaltkreisgeometrien im Computer abgespeichert sind und beliebig variiert werden können. Weiterhin sind durch Elektronenstrahlschreiben sehr hohe Auflösungen erreichbar, da schon mit einfachen elektronen-optischen Abbildungssystemen Elektronenfoki mit Durchmessern kleiner 100nm erreichbar sind. Nachteilig ist jedoch, daß das Verfahren durch das sequentielle, punktweise Beschreiben sehr zeitaufwendig ist. Das Elektronenstrahlschreiben wird heute deshalb vornehmlich zur Herstellung der in der Projektions-Lithographie erforderlichen Masken eingesetzt.

Gerätetechnisch bauen Elektronenstrahlschreiber in der Regel auf den gegenüber Transmissions-Elektronenmikroskopen wesentlich einfacheren Rasterelektronenmikroskopen auf. Zusätzlich zu den bei einem Rasterelektronenmikroskop üblichen Komponenten wird lediglich noch ein sogenannter Beamblanker benötigt, durch den der Elektronenstrahl auf eine Blende ablenkbar ist, um den Elektronenstrahl an den nicht zu belichtenden Stellen "aus" zu schalten.

Bei der Elektronenstrahl-Projektions-Lithographie wird analog zur optischen Lithographie ein größerer Teil einer Maske gleichzeitig ausgeleuchtet und durch eine Projektionsoptik verkleinert auf einen Wafer abgebildet. Da bei der Elektronenstrahl-Projektions-Lithographie simultan ein ganzes Feld abgebildet wird, sind die erzielbaren Durchsatzraten gegenüber Elektronenstrahlschreibern deutlich höher. Aufgrund der Linsenfehler nicht korrigierter elektronen-optischer Systeme lassen sich jedoch nur Unterfelder der Maske in der Größenordnung von etwa 1mm x 1mm gleichzeitig verkleinert auf den Wafer abbilden. Zur Belichtung eines gesamten Schaltkreises müssen diese Unterfelder durch eine elektronen-optische oder mechanische Verschiebung oder durch eine Kombination beider Verschiebungsverfahren aneinander gesetzt werden.

Ein entsprechendes Elektronenstrahl-Projektions-Lithographiesystem ist beispielsweise aus der US 3 876 883 bekannt. Dort ist auch bereits beschrieben, daß zur Justierung von Maske und Wafer relativ zueinander die Erregung des Kondensors vor der Maske so variiert werden kann, daß der Elektronenstrahl auf die Maske fokussiert wird. Das nachfolgende Projektionssystem bildet dann den in der Maskenebene entstehenden Elektronenfokus auf den Wafer ab.

Weitere ähnliche Elektronenstrahl-Projektions-Lithographiesysteme sind beispielsweise in der US 4 140 913 und der EP 0 367 496 und in der US 5545 902 beschrieben.

Nachteilig an Elektronenstrahl-Projektions-Lithographiesystemen ist, daß für jede zu belichtende Struktur eine entsprechende Maske benötigt wird. Wegen der mit der Maskenherstellung verbundenen hohen Kosten ist die Anfertigung kundenspezifischer Schaltkreise mit geringen Stückzahlen wirtschaftlich nicht sinnvoll.

Eine bekannte Mischform zwischen dem Elektronenstrahlschreiben und der Elektronenstrahl-Projektions-Lithographie ist das Schreiben mit einem geformten Elektronenstrahl. Anstelle eines fokussierten Elektronenstrahls wird das Profil des Elektronenstrahls mit Hilfe einer Blende geformt und die Blende auf das zu belichtende Substrat projiziert. Die Blendenöffnungen weisen dabei geometrische Standardformen auf, wobei das auf dem Substrat zu erzeugende Gesamtmuster dann aus diesen geometrischen Standardformen zusammengesetzt wird. Diese Variante kommt daher ohne spezifische Masken aus, ist jedoch nur geringfügig schneller als das Schreiben mit einem fokussierten Elektronenstrahl und deutlich langsamer als die Elektronenstrahl-Projektions-Lithographie.

Ziel der vorliegenden Erfindung ist deshalb ein Verfahren und ein Elektronenstrahl-Projektions-Lithographiesystem anzugeben, mit dem kundenspezifische Schaltkreise auch in geringerer Stückzahl mit höherer Wirtschaftlichkeit herstellbar sind.

Dieses Ziel wind durch Elektronenstrahl-Projektions-Lithographiesysteme mit den Merkmalen der Ansprüche 1 und 3 und durch ein Verfahren mit den Merkmalen des Anspruches 12 gelöst. Vorteilhafte Ausgestaltungen der Erfindung ergeben sich aus den Merkmalen der abhängigen Ansprüche.

Die vorliegende Erfindung basiert auf einer Kombination der Elektronenstrahl-Projektions-Lithographie mit dem Elektronenstrahlschreiben in einem einzigen Gerät. Beim erfindungsgemäßen Verfahren wird zunächst in einem ersten Schritt eine Maske über ein Projektivsystem elektronen-optisch auf das zu belichtende Substrat abgebildet. Die Maske weist dazu die zu erzeugenden gröberen Strukturen und/oder universeller benötigten Strukturen auf. In einem zweiten Schritt wird dann durch Fokussierung des Elektronenstrahls in der Ebene der Maske oder durch Formung des Elektronenstrahls vor der Maskenebene durch eine Blende, weitere Abbildung des in der Maskenebene entstehenden Fokus oder des Bildes der vor der Maskenebene angeordneten Strahlformungsblende auf das zu belichtende Substrat und gezielte Auslenkung des Elektronenfokus oder des geformten Elektronenstrahls in der Substratebene durch ein Ablenksystem die in der Maske nicht vorhandene, jedoch benötigte Feinstruktur und/oder die in der Maske nicht vorhandenen, jedoch den Kundenwünschen entsprechenden Leiterbahnen und sonstigen Strukturen auf das Substrat geschrieben.

Das Elektronenstrahlschreiben erfolgt bei einer ersten Ausführungsform der Erfindung durch einen in der Substratebene fokussierten Elektronenstrahl. Bei einer zweiten Ausführungsform erfolgt das Elektronenstrahlschreiben mit einem durch eine Blende geformten Elektronenstrahl, wobei die Blende dann für Elektronen durchlässige, Standardformen aufweisende Bereiche enthält.

Beide Schritte der erfindungsgemäßen Kombination können natürlich zur Belichtung größerer Felder auf dem Substrat iterativ mehrfach hintereinander ausgeführt werden. Da beide Schritte mehrfach hintereinander mit dem selben Gerät ausgeführt werden, ist zwischen beiden Schritten keinerlei Neujustierung des Substrates relativ zur optischen Achse des Gerätes erforderlich.

Ein erfindungsgemäßes elektronen-optisches Lithographiesystem weist eine Elektronenquelle, einen vorzugsweise mehrstufigen Kondensor, eine hinter dem Kondensor vorgesehene Maskenebene und ein der Maskenebene nachfolgendes Projektivsystem auf. Das Projektivsystem ist dabei derart erregbar, daß die Maske verkleinert auf das zu belichtende Substrat abgebildet wird. Über eine Steuerung ist die Kondensorerregung derart umschaltbar, oder auf eine weitere Blende umlenkbar, daß der Elektronenstrahl alternativ entweder die Maskenebene über ein größeres Feld gleichmäßig ausleuchtet oder in der Maskenebene fokussiert ist oder in der Maskenebene einen kleinen geformten Strahlquerschnitt aufweist. Weiterhin ist ein Ablenksystem im oder vor dem Projektivsystem vorgesehen und derart ansteuerbar, daß ein fokussierter oder geformter Elektronenstrahl über das Substrat entlang abgespeicherter oder berechneter Bahnen bewegbar ist.

Im Unterschied zu dem aus der US 3 876 883 bekannten Lithographiesystem wird beim erfindungsgemäßen Lithographiesystem bei in der Maskenebene fokussiertem Elektronenstrahl der Elektronenstrahl mit dem Projektivscanner gescannt. Dazu ist der Projektivscanner mit einem Mustergenerator gekoppelt, der die zu schreibenden Strukturen erzeugt. Das Kondensor-Ablenksystem wird in diesem Schreibmode konstant so angesteuert, daß der Elektronenstrahl ein Loch in der Maske passieren kann.

Bei einem vorteilhaften Ausführungsbeispiel der Erfindung mit einem mehrstufigen Kondensor ist eine Kondensoraperturblende vorgesehen, die - in Strahlrichtung gesehen - vor der letzten Kondensorlinse vor der Maskenebene angeordnet ist. Die Ebene, in der diese Kondensoraperturblene angeordnet ist, sollte dabei mit derjenigen Ebene zusammenfallen, in der im Projektionsmode, also bei gleichförmiger Ausleuchtung der Maskenebene, ein Bild der Elektronenquelle entsteht. Diese Kondensoraperturblende ist dann im Projektionsmode ohne Bedeutung, und dient gleichzeitig im Schreibmode sowohl zur Definition der Beleuchtungsapertur als auch als Dunkelabtastblende, indem über ein Kondensorablenksystem der Elektronenstrahl an nicht zu belichtenden Stellen auf die Blende gelenkt wird.

Weiterhin ist vorzugsweise zwischen den Kondensorlinsen eine weitere Blende, eine Feldblende im Projektionsmode vorgesehen. Diese Feldblende ist dabei in einer Ebene angeordnet, die der quellenseitigen Gegenstandsebene der letzten Kondensorlinse entspricht und demzufolge von der letzten Kondensorlinse in die Maskenebene scharf abgebildet wird.

An dieser Stelle sei darauf hinzuweisen, daß die Umschaltung zwischen dem Schreibmode und dem Projektionsmode durch eine Änderung der Erregung, der ersten, quellenseitigen Kondensorlinsen oder durch gezielte Auslenkung des Elektronenstrahls auf eine Blende im Kondensor erfolgt und die letzte, der Maskenebene vorgeschaltete Kondensorlinse in beiden Modi konstant erregt ist, so daß die Brennebenen und die ein- und ausgangsseitigen Bildebenen der letzten Kondensorlinse in beiden Modi fest sind.

Bei einem weiterhin vorteilhaften Ausführungsbeispiel ist die letzte Kondensorlinse und die erste Projektivlinse durch eine einzige, sogenannte Kondensor-Objektiv-Einfeldlinse gebildet, wobei die Maskenebene in der Spaltmitte der Kondensor-Objektiv-Einfeldlinse liegt. Dadurch lassen sich die für Kondensor-Objektiv-Einfeldlinsen bekannten geringen axialen Fehlerkoeffizienten, insbesondere Farbfehlerkoeffizienten, realisieren.

Da beim erfindungsgemäßen System auch das Projektivsystem bei der Umschaltung zwischen Schreibmode und Projektionsmode bezüglich seiner Erregung nicht geändert wird, kann weiterhin auch die letzte Linse des Projektivsystems als Kondensor-Objektiv-Einfeldlinse ausgebildet sein, wobei dann nur die Wirkung des eingangsseitigen Feldes dieser Linse für die Abbildung des Elektronenstrahls genutzt wird. Obwohl dieses auf den ersten Blick überdimmensioniert erscheinen mag, da von dieser zweiten Kondensor-Obj ektiv-Einfeldlinse nur das eingangsseitige Teilfeld ausgenutzt wird, ergeben sich dennoch einige Vorteile. Da das Gesamtsystem trotz seiner hohen Flexibilität lediglich zwei Kondensorlinsen und zwei Kondensor-Objektiv-Einfeldlinsen aufzuweisen braucht, wobei die beiden Kondensor-Objektiv-Einfeldlinsen einen im wesentlichen identischen Aufbau haben können und sich nur hinsichtlich eines linearen Skallierungsfaktors unterscheiden sollten, der dem Abbildungsmaßstab zwischen der Maskenebene und der Substratebene entspricht, ergibt sich zunächst ein herstellungstechnischer Vorteil. Bei einem geometrisch ähnlichen Aufbau beider Kondensor-Objektiv-Einfeldlinsen resultiert weiterhin eine entsprechende geometrische Ähnlichkeit der Magnetfelder beider Projektionslinsen, wodurch die außeraxialen Fehler, z.B. die isotrope und anisotrope Verzeichnung, beider Projektivlinsen gegenseitig kompensiert sein können. Für diese Fehlerkompensation sollten die beiden Kondensor-Objektiv-Einfeldlinsen mit zueinander inverser Polarisation der fokussierenden Magnetfelder betrieben werden.

Ein weiterer Vorteil einer zweiten Kondensor-Objektiv-Einfeldlinse ist die gute Detektierbarkeit von aus dem zu belichtenden Substrat austretenden Sekundärelektronen, weil das Substrat in dem fokussierenden Magnetfeld der Kondensor-Objektiv-Einfeldlinse angeordnet ist und die Sekundärelektronen in bekannter Weise von diesem Magnetfeld eingesammelt werden.

Beim erfindungsgemäßen Verfahren und in Verbindung mit dem erfindungsgemäßen System kommt vorzugsweise eine Maske zur Anwendung, die voneinander durch Stege getrennte Unterfelder aufweist. Durch Auslenkung des Elektronenstrahls mit Hilfe des im Kondensor vorgesehenen Ablenksystems können dann nacheinander verschiedene Unterfelder gleichförmig ausgeleuchtet werden und nacheinander durch geeignete Rücklenkung des Elektronenstrahls durch das Ablenksystem im Projektivsystem räumlich aneinander anschließend projiziert werden.

Weiterhin weist die Maske vorzugsweise in den Stegen Löcher auf, deren Durchmesser größer als der Durchmesser des durch den Kondensor fokussierten Elektronenstrahls sind.
Auf diese Löcher wird dann der Elektronenstrahl im Schreibmode gelenkt, so daß der Elektronenstrahl die Maske ungehindert passieren kann. Eine geeignete Anordnung der Löcher gestattet weiterhin eine zumindest grobe Justierung der Maske zum Elektronenstrahl.

Zusätzlich zur sequentiellen Belichtung von Feinstrukturen bzw. kundenspezifischen Strukturen kann der in der Maskenebene fokussierte - oder vor der Maskenebene geformte - Elektronenstrahl natürlich auch zur Justierung der Unterfelder der Maske relativ zum zu belichtenden Substrat dienen, wie dieses in der eingangs genannten US 3 876 883 beschrieben ist. Weiterhin kann der in der Maskenebene fokussierte - oder vor der Maskenebene geformte - Elektronenstrahl auch zur Nachbelichtung von fehlerhaften Maskenstrukturen oder zur Beseitigung von Löchern in der Maske durch Elektronenenstrahl stimmulierte Metallausscheidungen und damit zur Maskenreparatur eingesetzt werden. Insgesamt zeichnet sich damit das erfindungsgemäße System durch sehr flexible Einsatzmöglichkeiten aus.

Nachfolgend werden Einzelheiten der Erfindung anhand der in den Figuren dargestellten Ausführungsbeispiele näher erläutert. Im einzelnen zeigen:
- Figur 1: eine schematische Darstellung eines ersten Ausführungsbeispiels für das elektronen-optische Lithographiesystem;
- Figur 2: ein Ausführungsbeispiel für eine in Verbindung mit dem Lithographiesystem aus Figur 1 in der Maskenebene eingesetzte Maske;
- Figur 3: eine Darstellung des nach sequentieller Projektion der Maske aus Figur 2 in der Substratebene entstehende zusammengesetzte Bild;
- Figur 4: eine schematische Darstellung des beleuchtungsseitigen Teils eines zweiten Ausführungsbeispiels für ein erfindungsgemäßes Lithographiesystem und

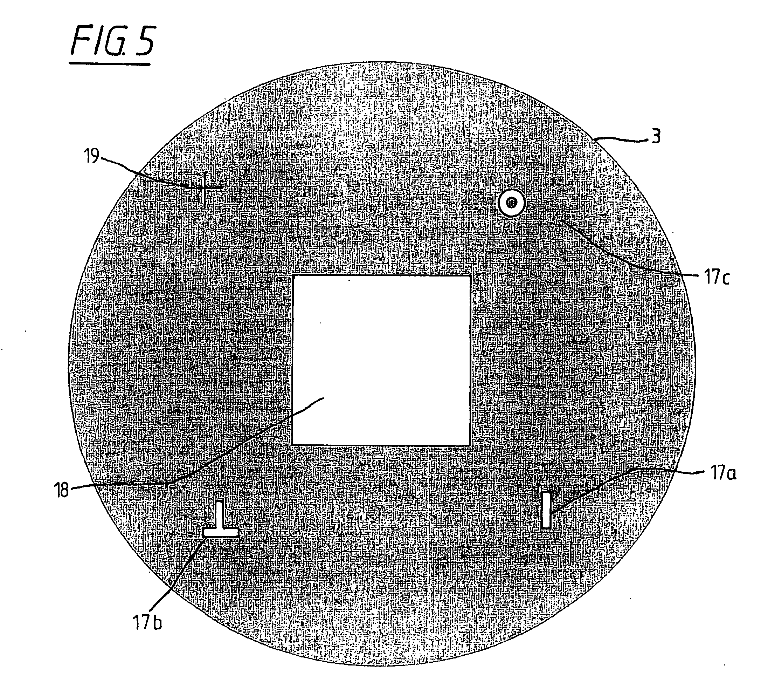

- Figur 5: eine Aufsicht auf eine beim Lithographiesystem nach Figur 4 eingesetzte Feldblende.

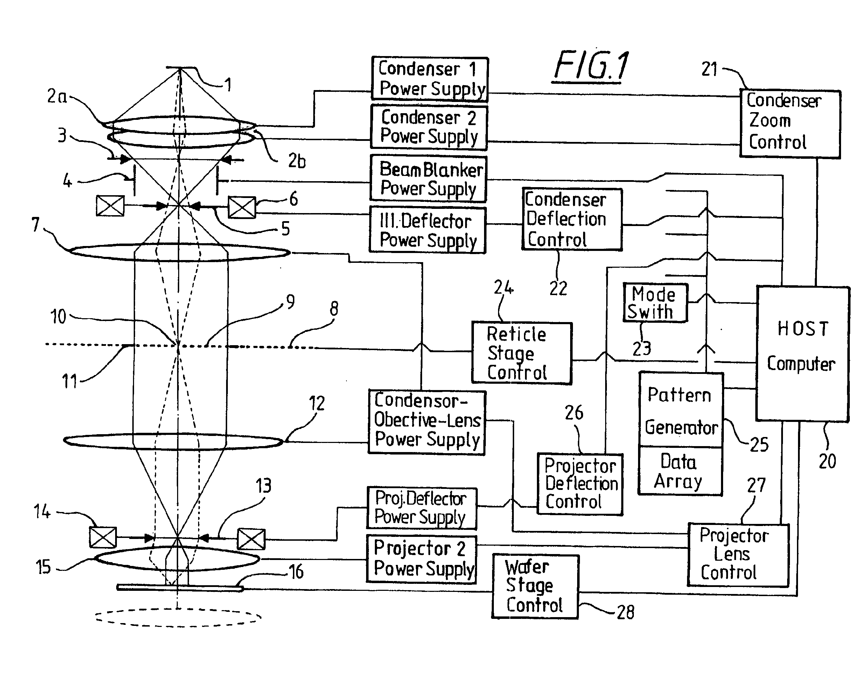

Das in der Figur 1 dargestellte Ausführungsbeispiel für ein Lithographiesystem weist eine Elektronenquelle (1), beispielsweise in Form eines thermischen Emitters wie einer LaB6-Kathode, und ein der Elektronenquelle nachgeschaltetes mehrstufiges Kondensorsystem auf. Die Elektronenquelle ist idealer Weise ihrerseits umschaltbar zwischen einem ersten Betriebsmodus mit relativ großflächiger Emission mit hohem Strom ( für den Projektionsmode) und einem zweiten Modus mit einem hohen Richtstrahlwert (für den Schreibmodus). Das mehrstufige Kondensorsystem enthält zwei quellenseitige Magnetlinsen (2a, 2b), sowie diesem nachgeschaltet das quellenseitige Vorfeld (7) einer Kondensor-Objektiv-Einfeldlinse (7, 12). In der quellenseitigen Gegenstandsebene des Vorfeldes (7) der Kondensor-Objektiv-Einfeldlinse ist eine Feldblende (3) und in der quellenseitigen Brennebene der Kondensor-Objektiv-Einfeldlinse (7, 12) ist eine Aperturblende (5) angeordnet. Zwischen diesen beiden Blenden ist ein schnelles elektrostatisches Ablenksystem (4), ein sogenannter Beamblanker vorgesehen, der dazu dient, zum Ausschalten des Elektronenstrahles den Elektronenstrahl auf die für Elektronen undurchlässigen Bereiche der Aperturblende (5) auszulenken. In der quellenseitigen Brennebene der Kondensor-Objektiv-Einfeldlinse (7, 12) ist weiterhin ein Kondensor-Ablenksystem (6) vorgesehen, das dazu dient, den Elektronenstrahl aus der optischen Achse gezielt auszulenken, so daß der Elektronenstrahl parallel zur optischen Achse verläuft und dadurch der Elektronenstrahl in der Maskenebene (8) unterschiedliche Subfelder (9) der Maske ausleuchtet. Die Maskenebene selbst befindet sich in der Mitte, d.h. im Polschuhspalt der Kondensor-Objektiv-Einfeldlinse (7, 12). In dieser Maskenebene ist ein in der Figur 1 nicht dargestellter Maskentisch angeordnet, der eine Verschiebung einer darauf angeordneten Maske in zwei zueinander senkrechten Richtungen senkrecht zur optischen Achse des elektronen-optischen Systems ermöglicht.

Das Kondensor-Ablenksystem (6) ist in der Figur 1 als einfaches Ablenksystem dargestellt. In der Praxis kann dieses Ablenksystem auch als Doppel-Ablenksystem ausgebildet sein, das eine Auslenkung des Elektronenstrahls in zwei zueinander senkrechten Richtungen mit einem virtuellen Kippunkt, der mit dem quellenseitigen Brennpunkt der Kondensor-Objektiv-Einfeldlinse (7, 12) zusammenfällt, ermöglicht.

Projektivseitig folgt dem von der Quelle (1) abgewandten Nachfeld (12) der Kondensor-Objektiv-Einfeldlinse (7, 12) ein Projektor-Ablenksystem (14), das ebenfalls eine Auslenkung des Elektronenstrahls aus der optischen Achse in zwei zueinander senkrechten Richtungen gestattet (und ebenfalls als Doppel-Ablenksystem ausgebildet sein kann) und eine letzte Projektionsstufe (15). Diese letzte Projektionsstufe (15) kann dabei wiederum das Vorfeld einer zweiten Kondensor-Objektiv-Einfeldlinse sein, die die gleiche Geometrie wie die erste Kondensor-Objektiv-Einfeldlinse (7, 12) aufweist, jedoch um einen linearen Skallierungsfaktor entsprechend dem Abbildungsmaßstab des Elektronenstrahlbündels in beiden Kondensor-Objektiv-Einfeldlinsen kleiner ausgebildet ist. Die Magnetfeldrichtung im Vorfeld der zweiten Kondensor-Objektiv-Einfeldlinse (15) ist invers zur Magnetfeldrichtung im Nachfeld (12) der ersten Kondensor-Objektiv-Einfeldlinse, so daß sich ein Teil der außeraxialen Fehlerkoeffizienten beider Linsen kompensieren.

Die in der Figur 1 dargestellten Strahlverläufe deuten die Abbildungsverhältnisse in den beiden verschiedenen Betriebsmodi des elektronen-optischen Systems an.

Im Projektionsmode sind die beiden quellenseitigen Kondensorlinsen (2a, 2b) gemeinsam so erregt, daß ein Bild der Elektronenquelle - genauer gesagt des Cross-Overs der Elektronenquelle - in die quellenseitige Brennebene der letzten Kondensorlinse (7), also in die quellenseitige Brennebene der ersten Kondensor-Objektiv-Einfeldlinse (7, 12) abgebildet ist. Dadurch wird in der Maskenebene (8) eine im wesentlichen parallele Ausleuchtung erreicht. In diesem Betriebsmode wird die Maskenebene (8) durch das Nachfeld (12) der ersten Kondensor-Objektiv-Einfeldlinse zusammen mit dem Vorfeld (15) der zweiten Kondensor-Objektiv-Einfeldlinse verkleinert in die Substratebene (16) abgebildet. In dieser Substratebene (16) ist der zu belichtende Wafer vorgesehen, der in bekannter Weise auf einem nicht dargestellten Wafertisch positioniert ist. Der Wafertisch ermöglicht es dabei, den Wafer mechanisch senkrecht zur optischen Achse des elektronen-optischen Systems zu verschieben, um dadurch die Belichtung größerer Felder zu ermöglichen. Die beiden Teilfelder (12, 15) der Kondensor-Objektiv-Einfeldlinsen, die das Projektivsystem bilden, bilden ein telezentrisches System, dessen vordere Brennebene mit der Maskenebene (8) und dessen hintere Brennebene mit der Substratebene (16) zusammenfällt.

Die Größe des in der Maskenebene (8) ausgeleuchteten Feldes ist dabei durch die Größe der Öffnung der Feldblende (3) bestimmt. Die Beleuchtungsapertur ist in diesem Betriebsmode durch eine Änderung der Einzelerregungen der beiden ersten Kondensorlinsen (2a, 2b), die gemeinsam ein Zoomsystem bilden, einstellbar. Bei einer Änderung der Beleuchtungsapertur erfolgt demzufolge eine Änderung der Einzelerregungen derart, daß beide Kondensorlinsen (2a, 2b) gemeinsam stets eine Abbildung der Quelle (1), bzw. deren Cross-Over, in die quellenseitige Brennebene des Vorfeldes (7) der Kondensor-Objektiv-Einfeldlinse (7, 12) gewährleisten.

Bei der Umschaltung in den Schreibmode wird lediglich die Erregung der beiden quellenseitigen Kondensorlinsen (2a, 2b) geändert, und zwar derart, daß beide Kondensorlinsen gemeinsam ein Bild der Quelle (1) in der Ebene der Feldblende (3) erzeugen. Die nachfolgende Kondensorlinse (7) und die Abbildungsstufen des Projektivsystems bleiben bei dieser Umschaltung unverändert. Dadurch ist gewährleistet, daß das Vorfeld (7) der Kondensor-Objektiv-Einfeldlinse (7, 12) den in der Feldblendenebene (3) entstehenden Elektronenfokus in die Maskenebene (8) abbildet und das nachfolgende Projektivsystem diesen Elektronenfokus verkleinert in die Substratebene abbildet.

Das Steuerungssystem für das elektronen-optische System ist schematisch auf der rechten Seite der Figur 1 dargestellt. Die Steuerung der elektronen-optischen Komponenten und der zugehörigen Kontrolleinheiten erfolgt durch einen Hostcomputer (20). Dieser Hostcomputer (20) steuert das Kontrollsystem (21) für die quellenseitigen Kondensorlinsen (2a, 2b). Weiterhin steuert der Hostcomputer (20) das Kontrollsystem (22) für das Kondensor-Ablenksystem (6), das Kontrollsystem (24) für den nicht dargestellten Retikeltisch, das Kontrollsystem (26) für das Projektiv-Ablenksystem (14), das Kontrollsystem (27) für das Projektivsystem (12, 15), einschließlich der letzten Kondensorlinse, die durch das Vorfeld (7) der ersten Kondensor-Objektiv-Einfeldlinsen gebildet wird und das Kontrollsystem (28) für den nicht dargestellten Wafertisch. Weiterhin steuert der Hostcomputer eine Umschalteinrichtung (23) für die Umschaltung zwischen beiden Betriebsmodi und einen Mustergenerator (25).

Im Projektionsmode ist der Mustergenerator (25) deaktiviert. Die Kontrolleinheiten für die elektronen-optischen Komponenten generieren dabei die Steuer- und Regelsignale für die einzelnen Strom- und Spannungsversorgungen, welche die entsprechenden Ströme und Spannungen für die elektronen-optischen Elemente wie Linsen und Ablenker erzeugen. Das Verfahren der Tische für die Maske und den Wafer sowie deren Positionskontrolle werden von den jeweiligen Tisch-Kontrolleinheiten (24, 28) geregelt.

Die Belichtung des Wafers erfolgt beim erfindungsgemäßen Verfahren in zwei Schritten. Nach Positionierung von Maske und Wafer werden zunächst durch Parallelprojektion ein oder mehrere Subfelder der Maske auf den Wafer abgebildet und der Wafer entsprechend belichtet, wobei durch entsprechende Regelsignale für die beiden quellenseitigen Kondensorlinsen (2a, 2b) eine achsenparallele Beleuchtung in der Maskenebene (8) gewährleistet ist. Nach Beendigung der Maskenbelichtung werden durch ein Steuersignal des Hostcomputers (20) die Kontrolleinheit (21) für die beiden quellenseitigen Kondensorlinsen (2a, 2b) und die Kontrolleinheit (22) für das Kondensor-Ablenksystem (6) so eingestellt, daß in einer freien Öffnung der Maske ein Bild der Elektronenquelle (1) entsteht. Gleichzeitig wird der Mustergenerator (25) und der Modenschalter (23) aktiviert. Die Aktivierung des Modenschalters (23) bewirkt dabei, daß nachfolgend in diesem Betriebsmode, dem Schreibmode, die Ansteuerung des schnellen Ablenksystems (4) im Kondensor, also des Beamblankers, und die Ansteuerung der Kontrolleinheit (26) für das Projektor-Ablenksystem (14) über den Mustergenerator (25) erfolgt. Mit Hilfe des Projektiv-Alenksystems wird der fokussierte Elektronenstrahl nun seriell an die zu belichtenden Stellen des Substrates geführt und der Beamblanker (4) zur Belichtung kurzzeitig deaktiviert. Ist die Belichtung abgeschlossen, werden die Maske und der Wafer relativ zueinander weitergefahren und es erfolgt die nachfolgende Belichtung bzw. Abbildung des nächsten Subfeldes der Maske.

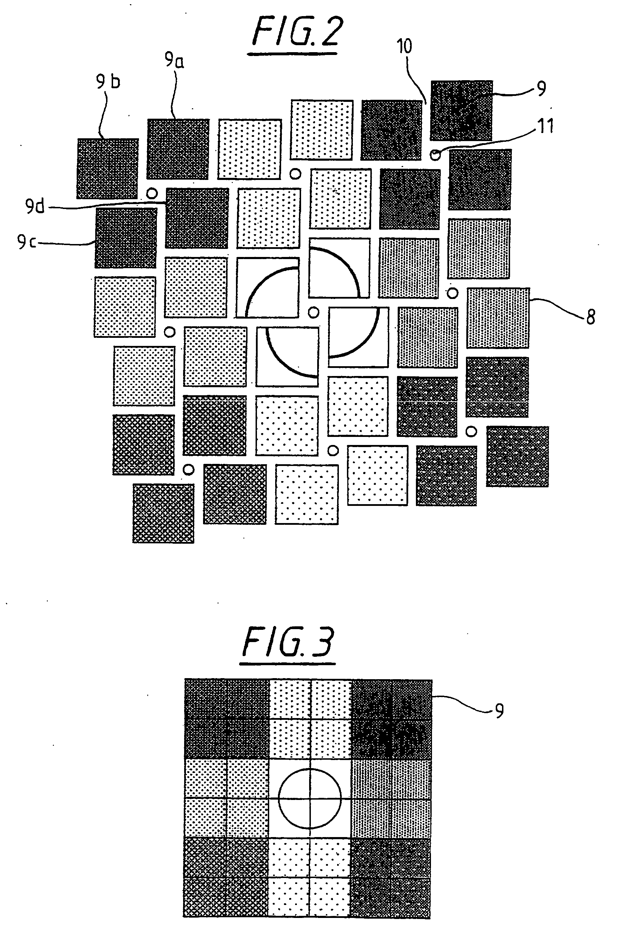

Eine Aufsicht auf eine exemplarische Maske ist in der Figur 2 dargestellt. Diese Maske weist eine Vielzahl, beim dargestellten Ausführungsbeispiel 6 x 6, quadratische Unterfelder (9) auf, die durch zwischen den Unterfeldern (9) liegende Stege (10) voneinander getrennt sind. Die einzelnen Unterfelder (9) weisen jeweils einen betreffenden Ausschnitt der aufzubelichtenden Struktur auf. Zwischen jeweils vier Unterfeldern (9) weisen die Trennstege (10) Durchgangslöcher (11) auf, deren Durchmesser so gewählt sind, daß sie größer als der Durchmesser des Elektronenfokus in der Maskenebene (8) bei fokussiertem Elektronenstrahl sind. Für die Elektronenstrahl-Projektions-Lithographie erzeugen die beiden quellenseitigen Kondensorlinsen (2a, 2b) ein Bild des Cross-Overs der Elektronenquelle (1) in der vorderen Brennebene der letzten Kondensorlinse (7) so daß eine achsenparallele Beleuchtung der Maske (8) jeweils in einem quadratischen Unterfeld gewährleistet ist. Mit Hilfe des Beleuchtungsablenksystems (6) kann das Bild der Leuchtfeldblende (3) dabei auf das jeweils auf zu belichtende Unterfeld (9) gelenkt werden. Das Projektionslinsensystem (12, 15) bildet die nacheinander beleuchteten Unterfelder (9) verkleinert in die Maskenebene (16) und damit auf den Wafer ab. Mit dem Projektions-Ablenksystem (14) werden dabei die einzelnen Unterfelder in der Substratebene nahtlos aneinander gesetzt. Dieses Ergebnis in der Substratebene ist in der Figur 3 dargestellt.

Wird dagegen im Schreibmode der Cross-Over der Elektronenquelle (1) durch die geänderte Erregung der beiden quellenseitigen Kondensorlinsen (2a, 2b) in die Maskenebene (8) abgebildet, so erzeugt die Projektionsoptik (12, 15) einen fokussierten Elektronenstrahl in der Substratebene (16) der mit dem Kondensor-Ablenksystem (14) zur sequentiellen Belichtung von Feinstrukturen an definierte Positionen in den Unterfeldern (9) geführt werden kann. Der Elektronenstrahl wird dazu mittels des Kondensor-Ablenksystems (6) so ausgelenkt, daß der Elektronenstrahl in der Maskenebene eines der Durchtrittslöcher (11) passiert. Sind die Durchmesser der Durchgangslöcher (11) in der Maske (8) nur unwesentlich größer als der Durchmesser des fokussierten Elektronenstrahls, oder ist eine geeignete Anordnung der Löcher beispielsweise analog zu einem Strichcode als Lochcode vorgesehen, so kann das durch die Löcher hindurchtretende Signal, beispielsweise durch abrastern der Lochkanten, auch zur Justierung der Maske relativ zur optischen Achse des Elektronenstrahls verwendet werden.

In den Figuren 2 und 3 sind jeweils 4 zueinander benachbarte Unterfelder, in deren Mitte jeweils ein Durchgangsloch (11) vorgesehen ist, mit jeweils gleicher Schraffur versehen. Jeweils vier solcher mit gleicher Schraffur versehene Unterfelder werden nacheinander durch eine reine elektronen-optische Relativverschiebung mit Hilfe der beiden Ablenksysteme (6, 14) abgebildet, ohne daß zwischenzeitlich eine mechanische Verschiebung von Maske und Wafer erfolgt. Nachdem jeweils vier Unterfelder (9a - 9d) mit gleicher Schraffur projiziert sind, erfolgt das Erzeugen der Feinstruktur durch Elektronenstrahlschreiben, indem der Elektronenstrahl auf das Durchgangsloch (11) zwischen den vier Unterfeldern fokussiert wird. Danach erfolgt eine Verschiebung von Wafer und Maske zueinander, so daß die nächsten vier Unterfelder sequentiell projiziert werden können.

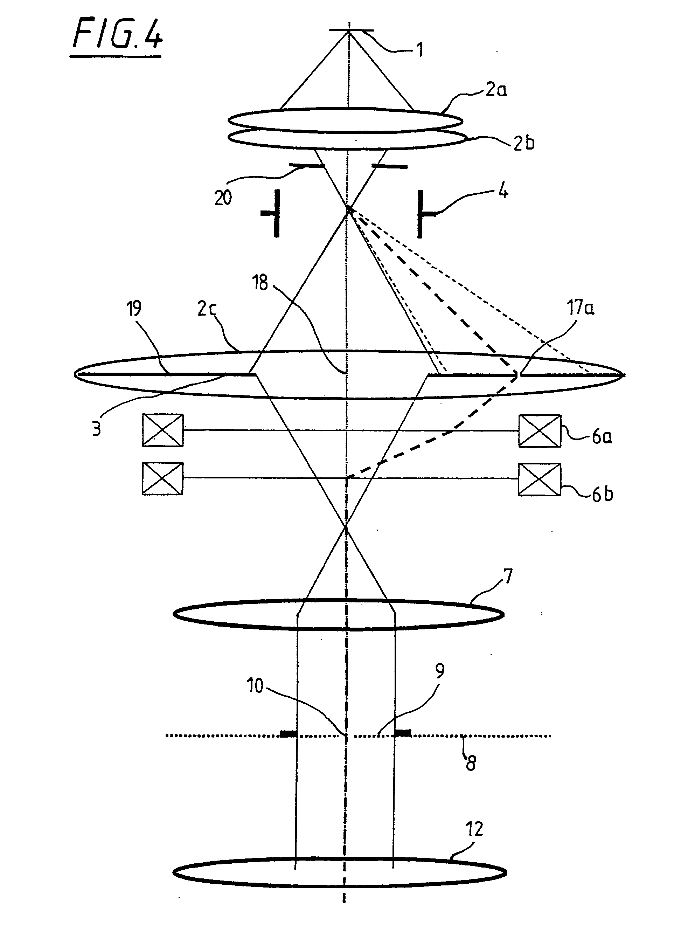

Das Ausführungsbeispiel in Figur 4 hat im wesentlichen einen sehr ähnlichen Aufbau wie das Ausführungsbeispiel in Figur 1. Demzufolge sind in der Figur 4 diejenigen Komponenten, die denen beim Ausführungsbeispiel in Figur 1 entsprechen, mit den selben Bezugszeichen versehen. Ein wesentlicher Unterschied zwischen beiden Ausführungsbeispielen ist darin zu sehen, daß insgesamt ein vierstufiger Kondensor vorgesehen ist, der sich dadurch ergibt, daß beim Ausführungsbeispiel nach Figur 1 zwischen den beiden quellenseitigen Kondensorlinsen (2a, 2b) und der letzten Kondensorlinse (7) (gebildet durch das Vorfeld der Kondensor-Objektiv-Einfeldlinse 7, 12) eine weitere Kondensorlinse (2c) vorgesehen ist. In der Hauptebene dieser weiteren Kondensorlinse (2c) ist eine modifizierte Feldblende (3) angeordnet, die zusätzlich zu der zentralen Öffnung, die für die Maskenprojektion das Feld des auszuleuchtenden Unterfeldes (9) definiert, weitere dezentrale Strukturen (17a, 17b, 17c, 19) aufweist. Durch eine geeignete Vorblende (20) wird die Ausleuchtung in der Leuchtfeldblende (3) so limitiert, daß nur ein Bereich ausgeleuchtet wird, der unwesentlich größer als der zentrale Bereich (18) der Blende (3) ist.

Bezüglich ihrer Positionierung entlang der optischen Achse des elektronen-optischen Systems ist die zusätzliche Kondensorlinse (2c) so angeordnet, daß deren Hauptebene mit der quellenseitigen Gegenstandsebene der letzten Kondensorlinse (7) bzw. des Vorfeldes der Kondensor-Objektiv-Einfeldlinse (7, 12) zusammenfällt. Die Feldblende (3) wird dadurch im Projektionsmode in die Maskenebene (8) abgebildet. Gleichzeitig werden im Unterschied zum Ausführungsbeispiel nach Figur 1 im Projektionsmode die beiden quellenseitigen Kondensorlinsen (2a, 2b) so erregt, daß in der Ebene des elektrostatischen Ablenksystems (4) ein Bild der Quelle entsteht, das nachfolgend durch die zusätzliche Kondensorlinse (2c) mit einem Abbildungsmaßstab von ca. 1:1, vorzugsweise mit einem Abbildungsmaßstab zwischen 0,5 :1 und 2 :1, in die quellenseitige Brennebene der letzten Kondensorlinse (7) abgebildet wird.

Bei diesem Ausführungsbeispiel kann nach Abschluß der Projektionsbelichtung der Elektronenstrahl durch das schnelle elektrostatische Ablenksystem (4) auf eine außerachsiale Öffnung der Feldblende (3) gelenkt werden. Durch die Brechkraft der zusätzlichen Kondensorlinse (2c) gemeinsam mit einem Doppelablenksystem (6a, 6b) wird der durch die außerachsiale Öffnung transmittierte Elektronenstrahl wieder auf die optische Achse und in Richtung der optischen Achse zurückgelenkt. Der durch die außerachsialen Öffnungen (17a, 17b, 17c) wie gewünscht geformte Elektronenstrahl kann nachfolgend eines der Durchgangslöcher (11) der Maske (8) ungehindert durchqueren. Analog zum Vorgehen bei der Projektionsbelichtung wird der so geformte Elektronenstrahl durch das nachfolgende, in der Figur 4 nicht mehr dargestellte Projektivsystem in die Substratebene abgebildet und mit Hilfe des Projektiv-Ablenksystems an die zu belichtende Stelle geführt.

Im Unterschied zum Ausführungsbeispiel nach Figur 1 bleibt bei diesem Ausführungsbeispiel die Erregung sämtlicher Linsen, also auch der quellenseitigen beiden ersten Kondensorlinsen (2a, 2b) bei der Umschaltung vom Projektionsmodus in den Schreibmodus unverändert. Im Schreibmodus wird der Strahlquerschnitt definiert durch die Form des ausgewählten außeraxialen Loches (17a, 17b, 17c) der Feldblende (3). Der durch eines der außeraxialen Löcher geformte Elektronenstrahl kann dann die Durchgangslöcher (11) der Maske (8) ungehindert passieren, da die Bilder der außeraxialen Löcher (17a, 17b, 17c) in der Maskenebene hinreichend klein sind.

Auf der Leuchtfeldblende (3) kann auch eine Position (19) ohne Öffnung vorgesehen sein, die durch das elektrostatische Ablenksystem (4) dann angefahren wird, wenn eine Dunkeltastung des Elektronenstrahls gewünscht ist.

Anhand der oben beschriebenen Ausführungsbeispiele wurde die Erfindung für den Fall erläutert, daß die letzte Kondensorlinse (7) gemeinsam mit der ersten Projektivlinse (12) als Kondensor-Objektiv-Einfeldlinse ausgebildet ist. Hierbei handelt es sich jedoch um ein vorteilhaftes Ausführungsbeispiel. Alternativ dazu können auch die letzte Kondensorlinse (7) und die erste Linse des Projektivsystems (12) jeweils als voneinander unabhängig einstellbare Einzellinsen ausgebildet sein. Dieses würde jedoch einen unnötigen Zusatzaufwand erfordern, da von einer voneinander unabhängigen Einstellung beider Linsen kein Gebrauch gemacht wird, und zu schlechteren Abbildungsleistungen führen.

## Patentansprüche

1. Elektronen-optisches Lithographiesystem mit einer Elektronenquelle (1), einem Kondensorsystem (2a, 2b, 7) mit mindestens zwei quellenseitigen Kondensorlinsen (2a, 2b) und einer letzten Kondensorlinse ( 7), einer hinter dem Kondensorsystem vorhandenen Maskenebene (8) und einem der Maskenebene (8) nachfolgenden Projektivsystem (12, 15), das derart erregbar ist, dass die Maskenebene (8) verkleinert in einer Substratebene (16) abbildbar ist, sowie mit einem Ablenksystem (14) im oder vor dem Projektivsystem (12, 15), **dadurch gekennzeichnet, dass** eine Steuerung (20, 21) zur Änderung der Kondensorerregung vorhanden ist, durch die die Kondensorerregung zwischen einem Projektionsmodus und einem Schreibmodus umschaltbar ist, wobei im Projektionsmodus die Steuerung die Kondensorlinsen (2a, 2b, 7) so erregt, dass der Crossover der Elektronenquelle (1) in die quellenseitige Brennebene (5) der letzten Kondensorlinse (7) abgebildet wird und wobei im Schreibmodus die Steuerung eine Änderung der Erregung des Kondensorsystems bewirkt, so dass der Crossover der Elektronenquelle (1) in der Maskenebene (8) abgebildet wird, und wobei im Schreibmodus das Ablenksystem (14) derart ansteuerbar ist, daß ein fokussierter Elektronenstrahl in der Substratebene (16) entlang abgespeicherter oder berechneter Bahnen bewegbar ist.

2. Elektronen-optisches Lithographiesystem nach Anspruche 1, wobei der Kondensor ein Ablenksystem (6) aufweist.

3. Elektronen-optisches Lithographiesystemmit einer Elektronenquelle (1), einem Kondensorsystem (2a, 2b, 7) mit mindestens zwei quellenseitigen Kondensorlinsen (2a, 2b) und einer letzten Kondensorlinse ( 7), einer hinter dem Kondensorsystem vorhandenen Maskenebene (8) und einem der Maskenebene (8) nachfolgenden Projektivsystem (12, 15), das derart erregbar ist, dass die Maskenebene (8) verkleinert in einer Substratebene (16) abbildbar ist, wobei im Kondensorsystem eine Feldblende (3) angeordnet ist, die von der letzten Kondensorlinse (7) in die Maskenebene abgebildet wird, und mit einer Steuerungseinrichtung (20 - 23, 25 - 27), die zwischen einem Projektionsmodus und einem Schreibmodus umschaltbar ist, wobei im Schreibmodus ein Ablenksystem (14) im oder vor dem Projektivsystem (12, 15) derart ansteuerbar ist, das ein Elektronenstrahl mit geformtem Strahlprofil in der Substratebene (16) entlang abgespeicherter oder berechneter Bahnen bewegbar ist, **dadurch gekennzeichnet, dass** die Feldblende (3) im Kondensorsystem neben einer zentralen Öffnung (18) mehrere dezentrale Öffnungen (17a, 17b, 17c) mit unterschiedlichen Standardformen zur Formung des Strahlprofils des Elektronenstrahls aufweist, und wobei ein Kondensorablenksystem sowie eine Steuerung (20, 22) zur Änderung der Erregung von Ablenkelementen (6a, 6b) in diesem Kondensorablenksystem vorhanden ist.

4. Elektronen-optisches Lithographiesystem nach einem der Anspruche 1-3 wobei eine Kondensoraperturblende (5) in der quellenseitigen Brennebene der letzten, der Elektronenquelle abgewandten Kondensorlinse (7) angeordnet ist.

5. Elektronen-optisches Lithographiesystem nach einem der Ansprüche 1 - 4, wobei eine Leuchtfeldblende (3) in einer zur Maskenebene (8) konjugierten Ebene vorgesehen ist.

6. Elektronen-optisches Lithographiesystem nach einem der Ansprüche 1 - 5, wobei die letzte Kondensorlinse (7) und die erste Projektivlinse (12) durch eine Kondensor-Objektiv-Einfeldlinse gebildet sind und die Maskenebene in der Spaltmitte der Kondensor-Objektiv-Einfeldlinse liegt.

7. Elektronen-optisches Lithographiesystem nach einem der Ansprüche 1 - 6 wobei eine zweite Kondensor-Objektiv-Einfeldlinse vorgesehen ist, die die letzte Projektivlinse (15) bildet.

8. Elektronen-optisches Lithographiesystem nach einem der Ansprüche 1 - 7, wobei die Linsen des Projektivsystems (12, 15) so erregt sind, dass das Projektivsystem ein telezentrisches System bildet, deren quellenseitige Brennebene mit der Maskenebene und deren von der Quelle abgewandte Brennebene mit der Präparatebene (16) zusammenfällt.

9. Elektronen-optisches Lithographiesystem nach einem der Ansprüche 1 - 8, wobei die Steuerung die letzte Kondensorlinse (7) und das Projektivsystem (12, 15) so erregt, dass diese sowohl im Projektionsmodus als auch im Schreibmodus eine jeweils gleiche Erregung aufweisen.

10. Elektronen-optisches Lithographiesystem nach Anspruch 2, wobei die Leuchtfeldblende (3) außeraxiale für Elektronen durchlässige Bereiche unterschiedlicher Formen zur Formung des Strahlprofils des Elektronenstrahls aufweist.

11. Verfahren zur Elektronenstrahl-Lithographie, bei dem in einem ersten Schritt eine Maske (8) über ein Projektivsystem (12, 15) elektronen-optisch auf ein zu belichtendes Substrat (16) abgebildet wird und in einem zweiten Schritt durch Fokussierung des Elektronenstrahls in der Ebene der Maske (8) oder Formung des Strahlprofils des Elektronenstrahls vor der Ebene der Maske (8) und Auslenkung des Elektronenfokus oder geformten Elektronenstrahls durch ein Ablenksystem (14) ein fokussierter Elektronenstrahl oder ein Elektronenstrahl mit geformtem Strahlprofil über ein in der Substratebene (16) angeordnetes Substrat geführt wird.

12. Verfahren nach Anspruch 11, wobei die Maske voneinander durch Stege (10) getrennte Unterfelder (9, 9a, 9b, 9c, 9d) aufweist, und wobei verschiedene Unterfelder (9, 9a, 9b, 9c, 9d) nacheinander durch Auslenkung des Elektronenstrahls durch ein in einem Kondensorsystem (2a, 2b, 7) vorgesehenes Ablenksystem ausgeleuchtet und nacheinander aneinander räumlich anschließend projiziert werden.

13. Verfahren nach Anspruch 12, wobei die Stege (10) Löcher aufweisen.

14. Verfahren nach Anspruch 13, wobei der Durchmesser der Löcher größer als der Durchmesser des durch das Kondensorsystem fokussierten Elektronenstrahls ist.

15. Verfahren nach Anspruch 14, wobei der Durchmesser der Löcher größer als die größte Abmessung des Strahlprofils des Elektronenstrahls in der Ebene der Maske (8) ist.

## Claims

1. Electron-optical lithography system comprising an electron source (1), a condenser system (2a, 2b, 7) comprising at least two source-side condenser lenses (2a, 2b) and a last condenser lens (7), a mask plane (8) present downstream of the condenser system, and a projective system (12, 15) that succeeds the mask plane (8) and can be excited in such a way that the mask plane (8) can be imaged in demagnefied fashion in a substrate plane (16), and also comprising a deflection system (14) in or upstream of the projective system (12, 15), **characterized in that** a control system (20, 21) for changing the condenser excitation is present, by means of which the condenser excitation can be changed over between a projection mode and a writing mode, wherein, in the projection mode, the control system excites the condenser lenses (2a, 2b, 7) in such a way that the crossover of the electron source (1) is imaged into the source-side focal plane (5) of the last condenser lens (7) and wherein, in the writing mode, the control system brings about a change in the excitation of the condenser system, such that the crossover of the electron source (1) is imaged in the mask plane (8), and wherein, in the writing mode, the deflection system (14) can be driven in such a way that a focused electron beam can be moved in the substrate plane (16) along stored or calculated paths.

2. Electron-optical lithography system according to Claim 1, wherein the condenser has a deflection system (6).

3. Electron-optical lithography system comprising an electron source (1), a condenser system (2a, 2b, 7) comprising at least two source-side condenser lenses (2a, 2b) and a last condenser lens (7), a mask plane (8) present downstream of the condenser system, and a projective system (12, 15) that succeeds the mask plane (8) and can be excited in such a way that the mask plane (8) can be imaged in demagnefied fashion in a substrate plane (16), wherein a field diaphragm (3) is arranged in the condenser system, said field diaphragm being imaged into the mask plane by the last condenser lens (7), and comprising a control device (20-23, 25-27), which can be changed over between a projection mode and a writing mode, wherein, in the writing mode, a deflection system (14) in or upstream of the projective system (12, 15) can be driven in such a way that an electron beam with a shaped beam profile can be moved in the substrate plane (16) along stored or calculated paths, **characterized in that** the field diaphragm (3) in the condenser system has, alongside a central opening (18), a plurality of decentralized openings (17a, 17b, 17c) having different standard shapes for shaping the beam profile of the electron beam, and wherein a condenser deflection system and also a control system (20, 22) for changing the excitation of deflection elements (6a, 6b) in said condenser deflection system are present.

4. Electron-optical lithography system according to any of Claims 1 to 3, wherein a condenser aperture diaphragm (5) is arranged in the source-side focal plane of the last condenser lens (7), remote from the electron source.

5. Electron-optical lithography system according to any of Claims 1-4, wherein a luminous field diaphragm (3) is provided in a conjugate plane with respect to the mask plane (8).

6. Electron-optical lithography system according to any of Claims 1-5, wherein the last condenser lens (7) and the first projective lens (12) are formed by a condenser-objective single field lens, and the mask plane lies in the gap centre of the condenser-objective single field lens.

7. Electron-optical lithography system according to any of Claims 1-6, wherein a second condenser-objective single field lens is provided, which forms the last projective lens (15).

8. Electron-optical lithography system according to any of Claims 1-7, wherein the lenses of the projective system (12, 15) are excited in such a way that the projective system forms a telecentric system whose source-side focal plane coincides with the mask plane and whose focal plane remote from the source coincides with the specimen plane (16).

9. Electron-optical lithography system according to any of Claims 1-8, wherein the control system excites the last condenser lens (7) and the projective system (12, 15) in such a way that they have an identical excitation in each case both in the projection mode and in the writing mode.

10. Electron-optical lithography system according to Claim 2, wherein the luminous field diagram (3) has abaxial regions - transmissive to electrons - of different shapes for shaping the beam profile of the electron beam.

11. Method for electron beam lithography, in which, in a first step, a mask (8) is imaged electron-optically onto a substrate (16) to be exposed by means of a projective system (12, 15) and, in a second step, a focused electron beam or an electron beam with a shaped beam profile is guided over a substrate arranged in the substrate plane (16) by focussing the electron beam in the plane of the mask (8) or shaping the beam profile of the electron beam upstream of the plane of the mask (8) and deflecting the electron focus or shaped electron beam by means of a deflection system (14).

12. Method according to Claim 11, wherein the mask has subfields (9, 9a, 9b, 9c, 9d) separated from one another by webs (10), and wherein different subfields (9, 9a, 9b, 9c, 9d), are successively illuminated by deflection of the electron beam by means of a deflection system provided in a condenser system (2a, 2b, 7) and are successively projected in a manner spatially adjoining one another.

13. Method according to Claim 12, wherein the webs (10) have holes.

14. Method according to Claim 13, wherein the diameter of the holes is larger than the diameter of the electron beam focused by the condenser system.

15. Method according to Claim 14, wherein the diameter of the holes is larger than the largest dimension of the beam profile of the electron beam in the plane of the mask (8).

## Revendications

1. Dispositif d'optique électronique pour la lithographie avec une source d'électrons (1), un dispositif condenseur (2a, 2b, 7) avec au moins deux lentilles condenseur (2a, 2b) du côté de la source et une dernière lentille condenseur (7), un plan de masque (8) existant derrière le dispositif condenseur et un dispositif projectif (12, 15) suivant le plan de masque (8), qui peut être excité de telle sorte que le plan de masque (8) peut être reproduit en réduction dans un plan de substrat (16), ainsi qu'avec un dispositif de déviation (14) dans ou sur le dispositif projectif (12, 15), **caractérisé en ce qu'**il existe une commande (20, 21) pour modifier l'excitation du condenseur qui permet de commuter l'excitation du condenseur entre un mode de projection et un mode d'écriture, la commande excitant les lentilles condenseur (2a, 2b, 7) dans le mode de projection de telle sorte que le crossover de la source d'électrons (1) est reproduit dans le plan focal (5) de la dernière lentille condenseur (7) du côté de la source et la commande provoquant une modification de l'excitation du dispositif condenseur dans le mode d'écriture de telle sorte que le crossover de la source d'électrons (1) est reproduit dans le plan de masque (8), et le dispositif de déviation (14) pouvant être commandé dans le mode d'écriture de telle sorte qu'un faisceau d'électrons focalisé puisse être déplacé dans le plan de substrat (16) le long de pistes enregistrées ou calculées.

2. Dispositif d'optique électronique pour la lithographie selon la revendication 1, dans lequel le condenseur comporte un dispositif de déviation (6).

3. Dispositif d'optique électronique pour la lithographie avec une source d'électrons (1), un dispositif condenseur (2a, 2b, 7) avec au moins deux lentilles condenseur (2a, 2b) du côté de la source et une dernière lentille condenseur (7), un plan de masque (8) existant derrière le dispositif condenseur et un dispositif projectif (12, 15) suivant le plan de masque (8), qui peut être excité de telle sorte que le plan de masque (8) peut être reproduit en réduction dans un plan de substrat (16), un diaphragme de champ (3) étant disposé dans le dispositif condenseur, qui est reproduit dans le plan de masque par la dernière lentille condenseur (7), et avec une installation de commande (20 - 23, 25 - 27) commutable entre un mode de projection et un mode d'écriture, un dispositif de déviation (14) dans ou sur le dispositif projectif (12, 15) pouvant être commandé dans le mode d'écriture de telle sorte qu'un faisceau d'électrons avec un profil de faisceau formé puisse être déplacé dans le plan de substrat (16) le long de pistes enregistrées ou calculées, **caractérisé en ce que** le diaphragme de champ (3) dans le dispositif condenseur comporte, à côté d'une ouverture centrale (18), plusieurs ouvertures décentrées (17a, 17b, 17c) de différentes formes standards pour la formation du profil de faisceau du faisceau d'électrons, et qu'il existe un dispositif de déviation du condenseur ainsi qu'une commande (20, 22) pour la modification de l'excitation d'éléments de déviation (6a, 6b) dans ce dispositif de déviation du condenseur.

4. Dispositif d'optique électronique pour la lithographie selon une des revendications 1 - 3, dans lequel un diaphragme d'ouverture du condenseur (5) est disposé dans le plan focal du côté de la source de la dernière des lentilles condenseur (7) opposée à la source d'électrons.

5. Dispositif d'optique électronique pour la lithographie selon une des revendications 1 - 4, dans lequel un diaphragme du champ d'illumination (3) est prévu dans un plan conjugué du plan de masque (8).

6. Dispositif d'optique électronique pour la lithographie selon une des revendications 1 - 5, dans lequel la dernière lentille condenseur (7) et la première lentille projective (12) sont formées par une lentille condenseur-objectif à champ unique et le plan de masque se trouve au milieu de la fente de la lentille condenseur-objectif à champ unique.

7. Dispositif d'optique électronique pour la lithographie selon une des revendications 1 - 6, dans lequel une deuxième lentille condenseur-objectif à champ unique est prévue, qui constitue la dernière lentille projective (15).

8. Dispositif d'optique électronique pour la lithographie selon une des revendications 1 - 7, dans lequel les lentilles du dispositif projectif (12, 15) sont excitées de telle sorte que le dispositif projectif constitue un dispositif télécentrique dont le plan focal du côté de la source se confond avec le plan de masque et le plan focal opposé à la source se confond avec le plan de la préparation (16).

9. Dispositif d'optique électronique pour la lithographie selon une des revendications 1 - 8, dans lequel la commande excite la dernière lentille condenseur (7) et le dispositif projectif (12, 15) de telle sorte que ceux-ci comportent respectivement la même excitation aussi bien dans le mode de projection que dans le mode d'écriture.

10. Dispositif d'optique électronique pour la lithographie selon la revendication 2, dans lequel le diaphragme du champ d'illumination (3) comporte des zones décentrées de différentes formes transparentes aux électrons pour la formation du profil de faisceau du faisceau d'électrons.

11. Procédé de lithographie par faisceau d'électrons dans lequel dans une première étape, on reproduit un masque (8) sur un substrat (16) à insoler au moyen d'un dispositif projectif (12, 15) d'optique électronique et dans une deuxième étape, la focalisation du faisceau d'électrons dans le plan du masque (8) ou la formation du profil de faisceau du faisceau d'électrons devant le plan du masque (8) et l'élongation de la focalisation des électrons ou la formation du faisceau d'électrons par un dispositif de déviation (14) permettent de guider un faisceau focalisé d'électrons ou un faisceau d'électrons avec un profil de faisceau mis en forme au-dessus d'un substrat disposé dans le plan du substrat (16).

12. Procédé selon la revendication 11, dans lequel le masque comporte des champs secondaires (9, 9a, 9b, 9c, 9d) séparés les uns des autres par des traverses (10) et dans lequel différents champs secondaires (9, 9a, 9b, 9c, 9d) sont éclairés successivement par la déviation du faisceau d'électrons à travers un dispositif de déviation prévu dans un dispositif condenseur (2a, 2b, 7) et sont projetés successivement sur des zones adjacentes les unes aux autres.

13. Procédé selon la revendication 12, dans lequel les traverses (10) comportent des trous.

14. Procédé selon la revendication 13, dans lequel le diamètre des trous est plus grand que le diamètre du faisceau d'électrons focalisé par le dispositif condenseur.

15. Procédé selon la revendication 14, dans lequel le diamètre des trous est plus grand que la plus grande mesure du profil de faisceau du faisceau d'électrons dans le plan du masque (8).
